# EUROPÄISCHE PATENTSCHRIFT

(11) **EP 3 176 832 B1**
(45) Veröffentlichungstag und Bekanntmachung des Hinweises auf die Patenterteilung: **05.06.2019**
(21) Anmeldenummer: 16201312.2
(22) Anmeldetag: 30.11.2016
(51) Int. Cl.: H01L 31/046, H01L 31/18

(54) **DÜNNSCHICHTSOLARMODUL**
THIN FILM SOLAR MODULE
PANNEAU SOLAIRE À COUCHE MINCE

(30) Priorität: 04.12.2015 DE 102015121141
(43) Veröffentlichungstag der Anmeldung: 07.06.2017
(73) Patentinhaber: Solibro Hi-Tech GmbH, 06766 Bitterfeld-Wolfen (DE)
(72) Erfinder: Gonçalves Dias Correia, Stélio Adalberto, 93047 Regensburg (DE); Marschall, Stephan, 04229 Leipzig (DE)
(74) Vertreter: adares Patent- und Rechtsanwälte Reininger & Partner GmbB

(56) Entgegenhaltungen:
- US-A1- 2003 116 185
- US-A1- 2012 103 401
- US-A1- 2015 020 868

## Beschreibung

Die Erfindung betrifft ein Dünnschichtsolarmodul. Im Unterschied zu Wafersolarmodulen, die üblicherweise Halbleiterwafer mit einer Dicke von etwa 120 µm bis 240 µm aufweisen, weisen Dünnschichtsolarmodule Dünnschichten mit einer Schichtdicke von Nanometern bis nur einigen Mikrometern auf. Das Dünnschichtsolarmodul weist ein Substrat mit Substratkanten und einem entlang der Substratkanten umlaufenden Randabschnitt auf. Auf dem Substrat ist ein Dünnschichtstapel angeordnet, der eine Rückelektrodenschicht, eine Aktivschicht und eine Frontelektrodenschicht aufweist. Die Rückelektrodenschicht ist auf dem Substrat angeordnet und durch eine Vielzahl an Rückelektrodenschicht-Trennrillen in Rückelektrodenschichtstreifen geteilt, die sich entlang einer Erstreckungsrichtung erstrecken. Die Rückelektrodenschicht-Trennrillen werden im Fachjargon auch als P1 scribes bezeichnet. Die Aktivschicht ist auf der Rückelektrodenschicht angeordnet und durch eine Vielzahl an Aktivschicht-Trennrillen, die oft auch als P2 scribes bezeichnet werden, in Aktivschichtstreifen geteilt, die sich entlang der Erstreckungsrichtung erstrecken. Die Frontelektrodenschicht ist auf der Aktivschicht angeordnet und durch eine Vielzahl an Frontelektrodenschicht-Trennrillen in Frontelektrodenschichtstreifen geteilt, die sich entlang der Erstreckungsrichtung erstrecken. Die Frontelektrodenschicht-Trennrillen werden oft auch als P3 scribes bezeichnet. Das Dünnschichtsolarmodul weist einen Randbereich auf, der sich senkrecht zu der Erstreckungsrichtung entlang des Randabschnitts des Substrats erstreckt, in dem das Substrat von der Rückelektrodenschicht, der Aktivschicht und der Frontelektrodenschicht unbedeckt ist. Von der Substratkante ausgehend sind Dünnschichtsolarmodule im Bereich von wenigen Millimetern entschichtet. Diese so genannte Randentschichtung erfolgt üblicherweise nach dem P3 scribe. Dafür kommen zum Beispiel mechanische und/oder optische Verfahren zum Einsatz, mit denen im Randbereich die Dünnschichtpakete bis hinunter zum Substrat entfernt werden. Im Ergebnis bleibt eine Dünnschichtpaket-Kante als Grenze zum Randbereich stehen. Optische Verfahren nutzen üblicherweise Laserenergieabsorption. Abhängig von Laserpulsenergie und Laserpulslänge werden die zu entfernenden Dünnschichten explosionsartig verdampft und reißen dabei benachbarte Bereiche mit fort. Daher kann es an der Dünnschichtpaket-Kante passieren, dass sich resublimiertes Material oder Bruchstücke abgesprengter Schichten auf der Stirnfläche der Dünnschichtpaket-Kante ablagern. In beiden Fällen eröffnet dies Wege unerwünschter Kriechströme, die zwischen Front- und Rückelektrode der Dünnschichtsolarzelle fließen.

Daher ist eine elektrisch möglichst saubere Trennung bzw. Isolierung zwischen der Frontelektrodenschicht und der Rückelektrodenschicht in dem Randabschnitt notwendig.

Ferner weist das Solarmodul eine elektrische Isolierungsrille auf, die sich senkrecht zu der Erstreckungsrichtung benachbart zu dem Randbereich erstreckt. Ein Solarmodul mit einer elektrischen Isolierungsrille ist sowohl in der US 2003/0116185 A1 als auch in der US2015/0020868A1 beschrieben.

Der Ausdruck "benachbart" ist im Sinne der Erfindung so zu verstehen, dass die benachbarten Schichten oder Strukturen beabstandet im Bereich eines Millimeters voneinander angeordnet sind oder unmittelbar aneinander angrenzend d.h. ohne dazwischen liegendes Material in unmittelbarem Kontakt zueinander angeordnet sind. Der Ausdruck "angrenzend" ist im Sinne der Erfindung so zu verstehen, dass die angrenzenden Schichten oder Strukturen ohne dazwischen liegendes Material in unmittelbarem Kontakt zueinander stehen.

In der elektrischen Isolierungsrille sind die Rückelektrodenschicht und die Frontelektrodenschicht voneinander elektrisch getrennt, um das Auftreten von Kriechströmen zu reduzieren oder zu eliminieren, da diese die Leistung des Dünnschichtsolarmoduls verringern. Dazu ist aus dem nicht druckschriftlich belegten Stand der Technik, eine Entschichtung mehrerer Schichten in der elektrischen Isolierungsrille bekannt. Diese wird über mechanische Prozesse oder mehrstufige Prozesse unter Verwendung eines Lasers ggf. in Kombination mit einem mechanischen Prozessschritt erzeugt. Es besteht weiterhin ein Bedarf an einem Dünnschichtsolarmodul, das einfach und kostengünstig herzustellen ist. Weiterhin besteht ein Bedarf an einem Dünnschichtsolarmodul mit einer verbesserten Leistung.

Die Aufgabe der Erfindung besteht darin, ein Dünnschichtsolarmodul bereitzustellen, das eine gute elektrische Isolierung zwischen der Frontelektrodenschicht und der Rückelektrodenschicht aufweist.

Die Aufgabe wird durch ein Dünnschichtsolarmodul mit den Merkmalen des Anspruchs 1 gelöst.

Erfindungsgemäß ist vorgesehen, dass die Rückelektrodenschicht unterhalb der elektrischen Isolierungsrille durch einen Isolierungsgraben begrenzt ist, der sich senkrecht zu der Erstreckungsrichtung erstreckt.

Dadurch, dass die Aktivschicht in der elektrischen Isolierungsrille von der Frontelektrodenschicht unbedeckt ist, wird eine einfachere elektrische Isolierung zwischen der Frontelektrodenschicht und der Rückelektrodenschichtermöglicht. Das Auftreten von Kriechströmen insbesondere an der Dünnschichtpaket-Kante im Randabschnitt des Dünnschichtsolarmoduls wird reduziert oder verhindert, was zu einer verbesserten Leistung des Solarmoduls führt. Das Dünnschichtsolarmodul ist außerdem einfach und kostengünstig herstellbar. Die Entfernung der Frontelektrodenschicht von der Aktivschicht in der elektrischen Isolierungsrille kann beispielsweise unter Verwendung eines Lasers in einem einstufigen Abtragverfahren realisiert werden. Durch den weiteren Isolierungsgraben werden die Frontelektrodenschicht und die Rückelektrodenschicht noch stärker elektrisch voneinander getrennt. Dadurch kann das Auftreten von Kriechströmen über die Dünnschichtpaket-Kante des Dünnschichtsolarmoduls noch weiter reduziert oder vermieden werden.

Unter dem Ausdruck "Aktivschicht" ist im Sinne der Erfindung eine photovoltaisch aktive Schicht zu verstehen, in der Elektronenakzeptoren und Elektronendonatoren auftreten. Die Aktivschicht ist ausgebildet, Licht in freie Ladungsträger umzuwandeln und wird auch als Absorberschicht bezeichnet.

Die elektrische Isolierungsrille ist beabstandet zum Randbereich angeordnet. D.h. zwischen der elektrischen Isolierungsrille und dem Randbereich ist vorzugsweise ein Schichtstapel aus der Rückelektrodenschicht, der Aktivschicht und der Frontelektrodenschicht auf dem Substrat angeordnet. Ein derartiges Dünnschichtsolarmodul kann durch Abtragen der Frontelektrodenschicht beabstandet zum Randbereich zum Erzeugen der elektrischen Isolierungsrille realisiert werden. Dieser Vorgang wird üblicherweise als Randentschichtung des Solarmoduls bezeichnet und ist in der Beschreibungseinleitung beschrieben worden.

In einer nicht-erfindungsgemäßen Ausführungsform ist die elektrische Isolierungsrille angrenzend zum Randbereich angeordnet. In dieser Ausführungsform bildet die elektrische Isolierungsrille mit dem Randbereich eine Stufenform aus, da die elektrische Isolierungsrille direkt im Anschluss zum Randbereich ausgebildet ist.

Das Dünnschichtsolarmodul weist vorzugsweise eine Pufferschicht auf, die auf der Aktivschicht angeordnet ist und durch die Vielzahl an Aktivschicht-Trennrillen geteilt ist. Während die Aktivschicht-Trennrillen die Aktivschicht und die Pufferschicht, wenn vorhanden, nicht aber die Rückelektrodenschicht teilen, teilen die Frontelektroden-Trennrillen die Frontelektrodenschicht, die Aktivschicht und die Pufferschicht, wenn vorhanden, aber nicht die Rückelektrodenschicht. Vorzugsweise bedeckt die Pufferschicht, wenn vorhanden, die Aktivschicht unterhalb der elektrischen Isolierungsrille.

In einer bevorzugten Ausführungsform weist das Dünnschichtsolarmodul eine nicht-leitende Barriereschicht auf, die als Diffusionsbarriere zwischen dem Substrat und der Rückelektrodenschicht wirkt. Das Substrat kann in dem Randbereich von der nicht-leitenden Barriereschicht bedeckt sein. In einer anderen Ausführungsvariante ist das Substrat in dem Randbereich von der nicht-leitenden Barriereschicht unbedeckt.

In einer bevorzugten Ausführungsform weisen die Aktivschicht-Trennrillen in Erstreckungsrichtung betrachtet eine kürzere Länge als die Rückelektrodenschicht-Trennrillen und die Frontelektrodenschicht-Trennrillen auf. Dadurch kann das Auftreten parasitärer Ströme noch weiter reduziert oder vermieden werden.

Vorzugsweise erstrecken sich die Aktivschicht-Trennrillen in der Erstreckungsrichtung betrachtet von einer elektrischen Isolierungsrille zu einer weiteren an einer gegenüberliegenden Substratkante verlaufenden elektrischen Isolierungsrille und erstrecken sich die Rückelektrodenschicht-Trennrillen und die Frontelektrodenschicht-Trennrillen in der Erstreckungsrichtung betrachtet von einem Randbereich zu einem weiteren an einer gegenüberliegenden Substratkante verlaufenden Randbereich. Unter der Formulierung, dass "sich die Aktivschicht-Trennrillen in der Erstreckungsrichtung betrachtet von einer elektrischen Isolierungsrille zu einer weiteren an einer gegenüberliegenden Substratkante verlaufenden elektrischen Isolierungsrille erstrecken" ist zu verstehen, dass die Aktivschicht-Trennrillen sich mindestens von einer elektrischen Isolierungsrille zu einer weiteren an einer gegenüberliegenden Substratkante verlaufenden elektrischen Isolierungsrille erstrecken, d.h. sich auch von einem Randbereich zu einem weiteren an einer gegenüberliegenden Substratkante verlaufenden Randbereich erstrecken können. In einer weiteren bevorzugten Ausführungsform weisen die Aktivschicht-Trennrillen in Erstreckungsrichtung betrachtet die gleiche Länge wie die Rückelektrodenschicht-Trennrillen und die Frontelektrodenschicht-Trennrillen auf.

In einer bevorzugten Ausführungsform ist das Dünnschichtsolarmodul als Substrat-Modul ausgebildet, dessen Aktivschicht als CIS- oder CIGS-Schicht ausgebildet ist. Die Schichtdicke der Aktivschicht liegt vorzugsweise im Bereich von 1000 bis 3000 nm, bevorzugter 1500 bis 2500 nm, noch bevorzugter 1700 bis 2200 nm. Vorzugsweise ist das Substrat als Glasscheibe ausgebildet. Das Substrat weist vorzugsweise eine Dicke von 1,5 bis 4,0 mm, bevorzugter 2,5 bis 3,5 mm, noch bevorzugter 2,7 bis 3,2 mm auf. Das Material der Rückelektrodenschicht weist bevorzugt überwiegend Molybdän auf. Die Schichtdicke der Rückelektrodenschicht liegt vorzugsweise im Bereich von 100 bis 500 nm, bevorzugter 200 bis 400 nm, noch bevorzugter 250 bis 350 nm. Das Material der Frontelektrodenschicht weist vorzugsweise ein transparentes, elektrisches leitfähiges Oxid (TCO) beispielsweise Indiumzinnoxid, Fluorzinnoxid, Aluminiumzinkoxid und/oder Antimonzinkoxid auf. Die Schichtdicke der Frontelektrodenschicht liegt vorzugsweise im Bereich von 850 bis 1200 nm, bevorzugter 900 bis 1150 nm, noch bevorzugter 1000 bis 1100 nm. Die nicht-leitende Barriereschicht, wenn vorhanden, weist vorzugsweise SiN (Siliziumnitrid) und bevorzugt eine Schichtdicke im Bereich von 50 bis 200nm, bevorzugter 70 bis 150nm, noch bevorzugter 100 bis 130 nm auf. Die Pufferschicht, wenn vorhanden, weist Cadmiumsulfid (CdS) auf und hat bevorzugt eine Schichtdicke im Bereich von 10 bis 200 nm, bevorzugter 30 bis 150 nm, noch bevorzugter 50 bis 80 nm auf. Das Substrat weist vorzugsweise folgende Abmessungen als Kantenlängen auf: 1190mm x 790mm. Die Breite des Randabschnittes beträgt vorzugsweise 10 bis 25 mm und bevorzugter 12 bis 20 mm. Alternativ bevorzugt kann die Breite des Randabschnittes auch im Bereich 0,5 bis 10 mm und bevorzugter 1 bis 5 mm sein.

Die Erfindung wird im Folgenden anhand von Ausführungsbeispielen unter Bezugnahme auf die Figuren erläutert. Hierbei zeigen:
- Fig. 1a: schematisch eine Teil-Querschnittsansicht eines Dünnschichtsolarmoduls gemäß einer nicht-erfindungsgemäßen Ausführungsform;
- Fig. 1b: schematisch eine Teil-Draufsicht auf das in Fig. 1a gezeigte Dünnschichtsolarmodul;
- Fig. 2a: schematisch eine Teil-Querschnittsansicht eines Dünnschichtsolarmoduls gemäß einer weiteren nichterfindungsgemäßen Ausführungsform;
- Fig. 2b: schematisch eine Teil-Draufsicht auf das in Fig. 2a gezeigte Dünnschichtsolarmodul;
- Fig. 3a: schematisch eine Teil-Querschnittsansicht eines Dünnschichtsolarmoduls gemäß einer weiteren nichterfindungsgemäßen Ausführungsform;
- Fig. 3b: schematisch eine Teil-Draufsicht auf das in Fig. 3a gezeigte Dünnschichtsolarmodul;
- Fig. 4a: schematisch eine Teil-Querschnittsansicht eines Dünnschichtsolarmoduls gemäß einer weiteren nichterfindungsgemäßen Ausführungsform;
- Fig. 4b: schematisch eine Teil-Draufsicht auf das in Fig. 4a gezeigte Dünnschichtsolarmodul;
- Fig. 5a: schematisch eine Teil-Querschnittsansicht eines Dünnschichtsolarmoduls gemäß einer Ausführungsform der Erfindung;
- Fig. 5b: schematisch eine Teil-Draufsicht auf das in Fig. 5a gezeigte Dünnschichtsolarmodul;
- Fig. 6a: schematisch eine Teil-Querschnittsansicht eines Dünnschichtsolarmoduls gemäß einer weiteren Ausführungsform der Erfindung;
- Fig. 6b: schematisch eine Teil-Draufsicht auf das in Fig. 6a gezeigte Dünnschichtsolarmodul;
- Fig. 7a: schematisch eine Teil-Querschnittsansicht eines Dünnschichtsolarmoduls gemäß einer weiteren Ausführungsform der Erfindung;
- Fig. 7b: schematisch eine Teil-Draufsicht auf das in Fig. 7a gezeigte Dünnschichtsolarmodul;
- Fig. 8a: schematisch eine Teil-Querschnittsansicht eines Dünnschichtsolarmoduls gemäß einer weiteren Ausführungsform der Erfindung; und
- Fig. 8b: schematisch eine Teil-Draufsicht auf das in Fig. 8a gezeigte Dünnschichtsolarmodul.

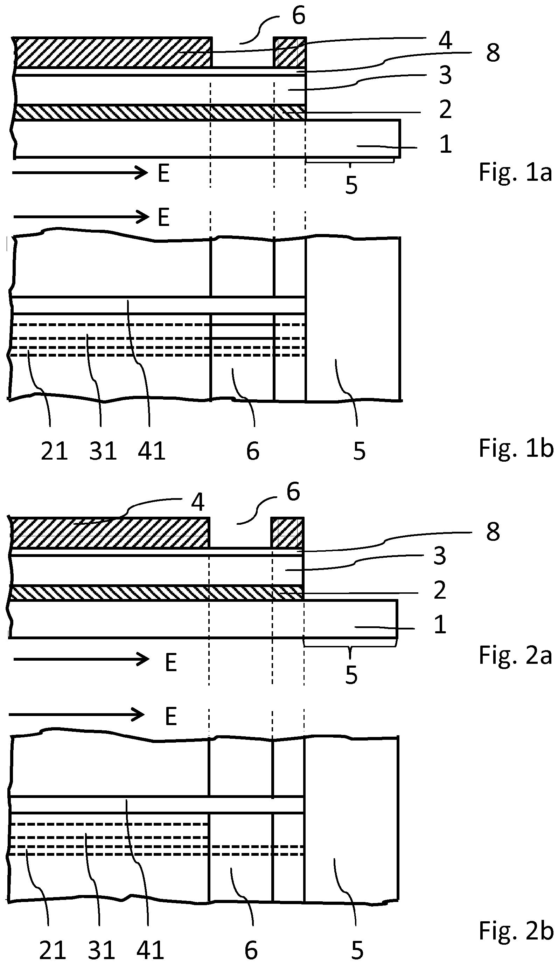

Fig. 1a zeigt schematisch und nicht maßstabsgerecht eine Teil-Querschnittsansicht eines Dünnschichtsolarmoduls gemäß einer nicht erfindungsgemäßen Ausführungsform. Das Dünnschichtsolarmodul weist ein Substrat 1 auf, auf dem ein Schichtstapel mit den nachfolgend beschriebenen Schichten angeordnet ist. Auf dem Substrat 1 ist eine Rückelektrodenschicht 2 angeordnet. Eine Aktivschicht 3 ist auf der Rückelektrodenschicht 2 angeordnet. Auf der Aktivschicht 3 ist eine Pufferschicht 8 angeordnet. Weiterhin ist eine Frontelektrodenschicht 4 auf der Pufferschicht 8 angeordnet. Das Dünnschichtsolarmodul weist den vorstehend beschriebenen Schichtstapel und einen entlang der Substratkanten (nicht gezeigt) umlaufenden Randabschnitt (nicht gezeigt) auf. Weiterhin weist das Dünnschichtsolarmodul einen Randbereich 5 auf, in dem das Substrat 1 von der Rückelektrodenschicht 2, der Aktivschicht 3, der Pufferschicht 8 und der Frontelektrodenschicht 4 unbedeckt ist. Der Randbereich 5 erstreckt sich senkrecht zu einer Erstreckungsrichtung E entlang des Randabschnitts des Substrats. Entlang der Erstreckungsrichtung E werden die Dünnschichten mit so genannten P1-, P2- und P3-Scribes strukturiert. In diesem Randbereich 5 ist die Randentschichtung des Dünnschichtsolarmoduls nach der Abscheidung und Strukturierung der Dünnschichten optisch und/oder mechanisch vorgenommen worden.

Benachbart insbesondere beabstandet zu dem Randbereich 5 erstreckt sich weiterhin eine elektrische Isolierungsrille 6 ebenfalls senkrecht zu der Erstreckungsrichtung E. In der elektrischen Isolierungsrille 6 ist die Aktivschicht 3 von der Frontelektrodenschicht 4 unbedeckt. Dadurch wird eine zusätzliche elektrische Isolierungsfunktion gegenüber Kriechströmen geschaffen, die über die Dünnschichtpaket-Kante zwischen Frontelektrode 4 und Rückelektrode 2 fließen. Die Pufferschicht 8 bedeckt die Aktivschicht 3 in der elektrischen Isolierungsrille 6.

Fig. 1b zeigt schematisch eine Teil-Draufsicht auf das in Fig. 1a gezeigte Dünnschichtsolarmodul. Die Rückelektrodenschicht (nicht gezeigt) ist durch eine Vielzahl an Rückelektrodenschicht-Trennrillen 21, von denen eine gestrichelt gezeigt ist, da sie in der Draufsicht auf das Dünnschichtsolarmodul eigentlich nicht sichtbar ist, in Rückelektrodenschichtstreifen (nicht gezeigt) geteilt, die sich entlang der Erstreckungsrichtung E erstrecken. Weiterhin ist die Aktivschicht (nicht gezeigt) durch eine Vielzahl an Aktivschicht-Trennrillen 31, von denen eine gestrichelt gezeigt ist, wenn sie in der Draufsicht auf das Dünnschichtsolarmodul nicht sichtbar ist, in Aktivschichtstreifen (nicht gezeigt) geteilt, die sich entlang der Erstreckungsrichtung E erstrecken. Ferner ist die Frontelektrodenschicht (nicht gezeigt) durch eine Vielzahl an Frontelektrodenschicht-Trennrillen 41, von denen eine gezeigt ist, in Frontelektrodenschichtstreifen (nicht gezeigt) geteilt, die sich entlang der Erstreckungsrichtung E erstrecken. Die Aktivschicht-Trennrillen 31, die Rückelektrodenschicht-Trennrillen 21 und die Frontelektrodenschicht-Trennrillen 41 weisen in Erstreckungsrichtung E betrachtet die gleiche Länge auf. Sie erstrecken sich in der Erstreckungsrichtung E betrachtet von einem Randbereich 5 zu einem weiteren an einer gegenüberliegenden Substratkante verlaufenden Randbereich (nicht gezeigt).

Fig. 2a zeigt schematisch eine Teil-Querschnittsansicht eines Dünnschichtsolarmoduls gemäß einer weiteren nicht-erfindungsgemäßen Ausführungsform, während Fig. 2b schematisch eine Teil-Draufsicht auf das in Fig. 2a gezeigte Dünnschichtsolarmodul zeigt. Das in Fig. 2a gezeigte Dünnschichtsolarmodul entspricht dem in Fig. 1a gezeigten Dünnschichtsolarmodul, während das in Fig. 2b gezeigte Dünnschichtsolarmodul dem in Fig. 1b gezeigten Dünnschichtsolarmodul entspricht mit dem Unterschied, dass die Aktivschicht-Trennrillen 31 in Erstreckungsrichtung E betrachtet eine kürzere Länge als die Rückelektrodenschicht-Trennrillen 21 und die Frontelektrodenschicht-Trennrillen 41 aufweisen. Dadurch wird ein zusätzlicher elektrischer Isolationseffekt zwischen der Potentialdifferenz von Frontelektrodenschicht 4 und Rückelektrodenschicht 2 hergestellt.

Die Aktivschicht-Trennrillen 31 erstrecken sich in der Erstreckungsrichtung E betrachtet von einer elektrischen Isolierungsrille 6 zu einer weiteren an einer gegenüberliegenden Substratkante verlaufenden elektrischen Isolierungsrille (nicht gezeigt), während sich die Rückelektrodenschicht-Trennrillen 21 und die Frontelektrodenschicht-Trennrillen 41 in der Erstreckungsrichtung E betrachtet von einem Randbereich 5 zu einem weiteren Randbereich 5 erstrecken. In dem Randbereich 5 ist das Substrat (nicht gezeigt) in Draufsicht sichtbar.

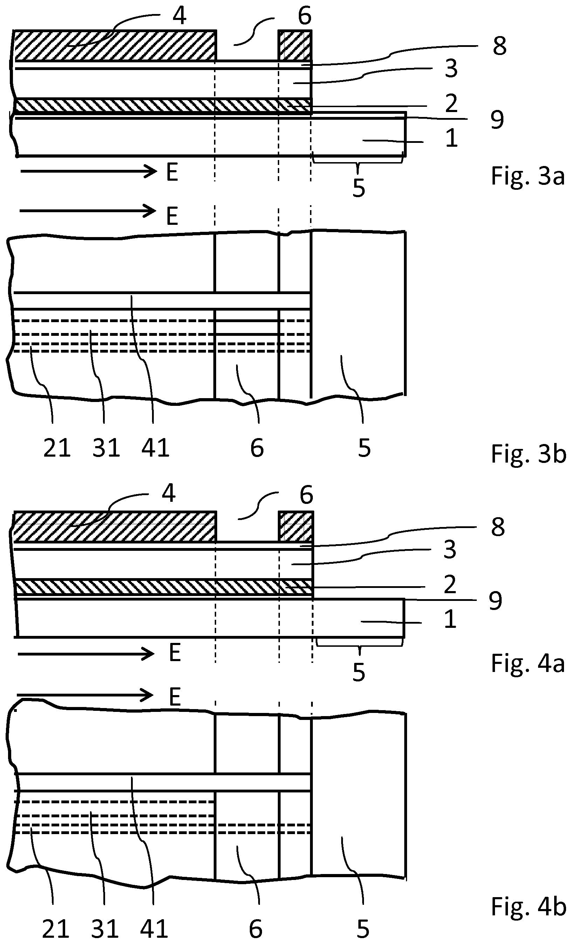

Fig. 3a zeigt schematisch eine Teil-Querschnittsansicht eines Dünnschichtsolarmoduls gemäß einer weiteren nicht-erfindungsgemäßen Ausführungsform, und Fig. 3b zeigt schematisch eine Teil-Draufsicht auf das in Fig. 3a gezeigte Dünnschichtsolarmodul. Das in Fig. 3a gezeigte Dünnschichtsolarmodul entspricht dem in Fig. 1a gezeigten Dünnschichtsolarmodul mit dem Unterschied, dass eine nicht-leitende Barriereschicht 9 auf dem Substrat 1 angeordnet ist. Die nicht-leitende Barriereschicht 9 ist zwischen dem Substrat 1 und der Rückelektrodenschicht 2 angeordnet und erstreckt sich in dem Randbereich 5, sodass sie das Substrat 5 in dem Randbereich 5 bedeckt. Das in Fig. 3b gezeigte Dünnschichtsolarmodul entspricht dem in Fig. 1b gezeigten Dünnschichtsolarmodul mit dem Unterschied, dass in dem Randbereich 5 die nicht-leitende Barriereschicht (nicht gezeigt) anstelle des Substrats (nicht gezeigt) sichtbar ist. Die zu der ersten und zweiten Ausführungsform gemachten Ausführungen gelten für die dritte Ausführungsform entsprechend.

Fig. 4a zeigt schematisch eine Teil-Querschnittsansicht eines Dünnschichtsolarmoduls gemäß einer weiteren nicht-erfindungsgemäßen Ausführungsform, und Fig. 4b zeigt schematisch eine Teil-Draufsicht auf das in Fig. 4a gezeigte Dünnschichtsolarmodul. Das in Fig. 4a gezeigte Dünnschichtsolarmodul entspricht dem in Fig. 3a gezeigten Dünnschichtsolarmodul mit dem Unterschied, dass die nicht-leitende

Barriereschicht 9 das Substrat 1 im Randbereich 5 nicht bedeckt, während das in Fig. 4b gezeigte Dünnschichtsolarmodul dem in Fig. 3b gezeigten Dünnschichtsolarmodul entspricht mit dem Unterschied, dass die Aktivschicht-Trennrillen 31 in Erstreckungsrichtung E betrachtet eine kürzere Länge als die Rückelektrodenschicht-Trennrillen 21 und die Frontelektrodenschicht-Trennrillen 41 aufweisen und in dem Randbereich 5 das Substrat (nicht gezeigt) anstelle der nicht-leitenden Barriereschicht (nicht gezeigt) sichtbar ist. In der vierten Ausführungsform erstrecken sich die Aktivschicht-Trennrillen 31 in der Erstreckungsrichtung E betrachtet von einer elektrischen Isolierungsrille 6 zu einer weiteren an einer gegenüberliegenden Substratkante verlaufenden elektrischen Isolierungsrille (nicht gezeigt), während sich die Rückelektrodenschicht-Trennrillen 21 und die Frontelektrodenschicht-Trennrillen 41 in der Erstreckungsrichtung E betrachtet von einem Randbereich 5 zu einem weiteren Randbereich 5 erstrecken. Dadurch wird wie bei der zweiten Ausführungsform ein zusätzlicher elektrischer Isolationseffekt zwischen der Potentialdifferenz von Frontelektrodenschicht 4 und Rückelektrodenschicht 2 hergestellt.

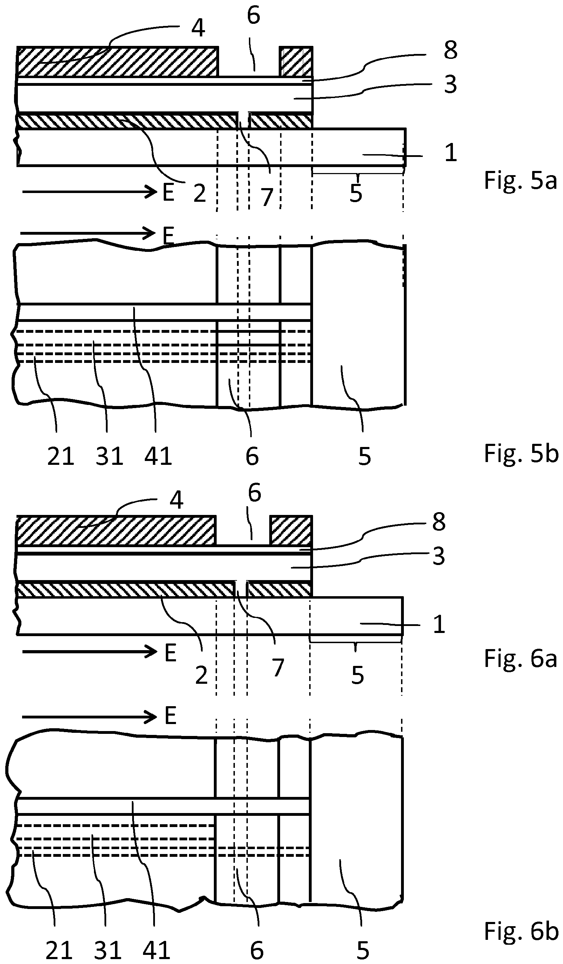

Fig. 5a zeigt schematisch eine Teil-Querschnittsansicht eines Dünnschichtsolarmoduls gemäß einer Ausführungsform der Erfindung, während Fig. 5b schematisch eine Teil-Draufsicht auf das in Fig. 5a gezeigte Dünnschichtsolarmodul zeigt. Das in Fig. 5a gezeigte Dünnschichtsolarmodul entspricht dem in Fig. 1a gezeigten Dünnschichtsolarmodul mit dem Unterschied, dass die Rückelektrodenschicht 2 unterhalb der elektrischen Isolierungsrille 6 durch einen weiteren Isolierungsgraben 7 begrenzt ist, der sich senkrecht zu der Erstreckungsrichtung E erstreckt. Durch diesen weiteren Isolierungsgraben 7 werden die Frontelektrodenschicht 4 und die Rückelektrodenschicht 2 noch stärker elektrisch voneinander getrennt. Das in Fig. 5b gezeigte Dünnschichtsolarmodul entspricht dem in Fig. 1b gezeigten Dünnschichtsolarmodul mit dem Unterschied, dass der in Fig. 5b nicht sichtbare Isolierungsgraben 7 gestrichelt dargestellt ist.

Fig. 6a zeigt schematisch eine Teil-Querschnittsansicht eines Dünnschichtsolarmoduls gemäß einer weiteren Ausführungsform der Erfindung, und Fig. 6b zeigt schematisch eine Teil-Draufsicht auf das in Fig. 6a gezeigte Dünnschichtsolarmodul. Das in Fig. 6a gezeigte Dünnschichtsolarmodul entspricht dem in Fig. 5a gezeigten Dünnschichtsolarmodul, während das in Fig. 6b gezeigte Dünnschichtsolarmodul dem in Fig. 5b gezeigten Dünnschichtsolarmodul entspricht mit dem Unterschied, dass die Aktivschicht-Trennrillen 31 in Erstreckungsrichtung E betrachtet eine kürzere Länge als die Rückelektrodenschicht-Trennrillen 21 und die Frontelektrodenschicht-Trennrillen 41 aufweisen. Im übrigen gelten die Ausführungen, die zur zweiten Ausführungsform des Dünnschichtsolarmoduls gemacht worden sind.

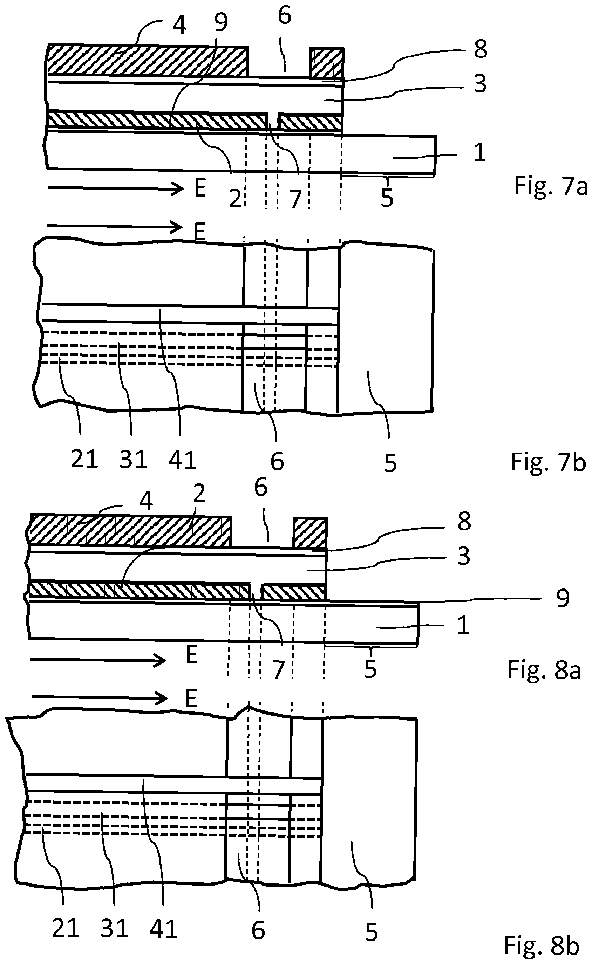

Fig. 7a zeigt schematisch eine Teil-Querschnittsansicht eines Dünnschichtsolarmoduls gemäß einer weiteren Ausführungsform der Erfindung, und Fig. 7b zeigt schematisch eine Teil-Draufsicht auf das in Fig. 7a gezeigte Dünnschichtsolarmodul. Das in Fig. 7a gezeigte Dünnschichtsolarmodul entspricht dem in Fig. 5a gezeigten Dünnschichtsolarmodul mit dem Unterschied, dass auf dem Substrat 1 eine nicht-leitende Barriereschicht 9 derart angeordnet ist, dass sie sich zwischen dem Substrat 1 und der Rückelektrodenschicht 2 erstreckt, aber das Substrat 1 im Randbereich 5 von der nicht-leitenden Barriereschicht 9 unbedeckt ist. Das in Fig. 7b gezeigte Dünnschichtsolarmodul entspricht dem in Fig. 5b gezeigtem Solarmodul, die nicht-leitende Barriereschicht ist in der in Fig. 7b gezeigten Draufsicht nicht sichtbar.

Fig. 8a zeigt schematisch eine Teil-Querschnittsansicht eines Dünnschichtsolarmoduls gemäß einer weiteren Ausführungsform der Erfindung, und Fig. 8b zeigt schematisch eine Teil-Draufsicht auf das in Fig. 8a gezeigte Dünnschichtsolarmodul. Das in Fig. 8a gezeigte Dünnschichtsolarmodul entspricht dem in Fig. 5a gezeigten Dünnschichtsolarmodul mit dem Unterschied, dass auf dem Substrat 1 eine nicht-leitende Barriereschicht 9 derart angeordnet ist, dass sie sich zwischen dem Substrat 1 und der Rückelektrodenschicht 2 erstreckt und das Substrat 1 im Randbereich 5 bedeckt. Das in Fig. 8b gezeigte Dünnschichtsolarmodul entspricht dem in Fig. 5b gezeigtem Solarmodul mit dem Unterschied, dass im Randbereich 5 die nicht-leitende Barriereschicht (nicht gezeigt) anstelle des Substrats (nicht gezeigt) sichtbar ist.

### Bezugszeichenliste

- E: Erstreckungsrichtung
- 1: Substrat
- 2: Rückelektrodenschicht
- 21: Rückelektrodenschicht-Trennrille
- 3: Aktivschicht
- 31: Aktivschicht-Trennrille
- 4: Frontelektrodenschicht
- 41: Frontelektrodenschicht-Trennrille
- 5: Randbereich
- 6: elektrische Isolierungsrille
- 7: Isolierungsgraben
- 8: Pufferschicht
- 9: nicht-leitende Barriereschicht

## Patentansprüche

1. Dünnschichtsolarmodul, aufweisend
- ein Substrat (1) mit Substratkanten und einem entlang der Substratkanten umlaufenden Randabschnitt;
- eine Rückelektrodenschicht (2), die auf dem Substrat (1) angeordnet und durch eine Vielzahl an Rückelektrodenschicht-Trennrillen (21) in Rückelektrodenschichtstreifen geteilt ist, die sich entlang einer Erstreckungsrichtung (E) erstrecken;
- eine Aktivschicht (3), die auf der Rückelektrodenschicht (2) angeordnet und durch eine Vielzahl an Aktivschicht-Trennrillen (31) in Aktivschichtstreifen geteilt ist, die sich entlang der Erstreckungsrichtung (E) erstrecken;
- eine Frontelektrodenschicht (4), die auf der Aktivschicht (3) angeordnet und durch eine Vielzahl an Frontelektrodenschicht-Trennrillen (41) in Frontelektrodenschichtstreifen geteilt ist, die sich entlang der Erstreckungsrichtung (E) erstrecken;
- einen Randbereich (5), der sich senkrecht zu der Erstreckungsrichtung (E) entlang des Randabschnitts des Substrats erstreckt, in dem das Substrat (1) von der Rückelektrodenschicht (2), der Aktivschicht (3) und der Frontelektrodenschicht (4) unbedeckt ist; und
- eine elektrische Isolierungsrille (6), die sich senkrecht zu der Erstreckungsrichtung (E) beabstandet zu dem Randbereich (5) erstreckt;
wobei die Aktivschicht (3) in der elektrischen Isolierungsrille (6) von der Frontelektrodenschicht (4) unbedeckt ist, **dadurch gekennzeichnet, dass** die Rückelektrodenschicht (2) unterhalb der elektrischen Isolierungsrille (6) durch einen Isolierungsgraben (7) begrenzt ist, der sich senkrecht zu der Erstreckungsrichtung (E) erstreckt.

2. Dünnschichtsolarmodul nach einem der vorangehenden Ansprüche, **gekennzeichnet durch** eine Pufferschicht (8), die auf der Aktivschicht (3) angeordnet ist und durch die Vielzahl an Aktivschicht-Trennrillen (31) geteilt ist.

3. Dünnschichtsolarmodul nach einem der vorangehenden Ansprüche, **gekennzeichnet durch** eine nicht-leitende Barriereschicht (9), die als Diffusionsbarriere zwischen dem Substrat (1) und der Rückelektrodenschicht (2) wirkt.

4. Dünnschichtsolarmodul nach Anspruch 3, **dadurch gekennzeichnet, dass** das Substrat (1) in dem Randbereich (5) von der nicht-leitenden Barriereschicht (9) unbedeckt ist.

5. Dünnschichtsolarmodul nach einem der vorangehenden Ansprüche, **dadurch gekennzeichnet, dass** die Aktivschicht-Trennrillen (31) in Erstreckungsrichtung (E) betrachtet eine kürzere Länge als die Rückelektrodenschicht-Trennrillen (21) und die Frontelektrodenschicht-Trennrillen (41) aufweisen.

6. Dünnschichtsolarmodul nach einem der vorangehenden Ansprüche, **dadurch gekennzeichnet, dass** sich die Aktivschicht-Trennrillen (31) in der Erstreckungsrichtung (E) betrachtet von einer elektrischen Isolierungsrille (6) zu einer weiteren an einer gegenüberliegenden Substratkante verlaufenden elektrischen Isolierungsrille (6) erstrecken und die Rückelektrodenschicht-Trennrillen (21) und die Frontelektrodenschicht-Trennrillen (41) in der Erstreckungsrichtung (E) betrachtet von einem Randbereich (5) zu einem weiteren an einer gegenüberliegenden Substratkante verlaufenden Randbereich (5) erstrecken.

7. Dünnschichtsolarmodul nach einem der vorangehenden Ansprüche, **dadurch gekennzeichnet, dass** das Dünnschichtsolarmodul als Substrat-Modul ausgebildet ist, dessen Aktivschicht (3) als CIS- oder CIGS-Schicht ausgebildet ist.

## Claims

1. A thin-film solar module, comprising
- a substrate (1) with substrate edges and a border section running along the substrate edges;
- a back electrode layer (2) disposed on the substrate (1) and divided by a plurality of back electrode layer separating grooves (21) in back electrode layer strips extending along an extending direction (E);
- an active layer (3) disposed on the back electrode layer (2) and divided by a plurality of active layer separation grooves (31) in active layer strips extending along the extending direction (E);
- a front electrode layer (4) disposed on the active layer (3) and divided by a plurality of front electrode layer separating grooves (41) in front electrode layer strips extending along the extending direction (E);
- an border region (5) extending perpendicular to the extension direction (E) along the edge section of the substrate in which the substrate (1) is uncovered from the back electrode layer (2), the active layer (3) and the front electrode layer (4); and
- an electric insulation groove (6) extending perpendicularly to the extension direction (E) and arranged at a distance from the border region (5),
wherein that the active layer (3) in the electrical insulation groove (6) is uncovered from the front electrode layer (4)
**characterized in that** the back electrode layer (2) below the electrical insulation groove (6) is limited by an isolation trench (7) which extends perpendicular to the extension direction (E).

2. The thin-film solar module according to one of the preceding claims, **characterized by** a buffer layer (8) which is arranged on the active layer (3) and is divided by the plurality of active layer separating grooves (31).

3. The thin-film solar module according to one of the preceding claims, **characterized by** a non-conductive barrier layer (9) which acts as a diffusion barrier between the substrate (1) and the back electrode layer (2).

4. The thin-film solar module according to claim 3, **characterized in that** the substrate (1) is uncovered from the non-conductive barrier layer (9) in the border region (5).

5. The thin-film solar module according to one of the preceding claims, **characterized in that** the active-layer separation grooves (31) seen in the extension direction (E) has a shorter length than the back electrode layer separating grooves (21) and the front electrode layer separating grooves (41).

6. The thin-film solar module according to one of the preceding claims, **characterized in that** the active layer separation grooves (31) seen in the extension direction (E) extend from an electrical insulation groove (6) to another electrical insulation groove (6) running along an opposite substrate edge and the back electrode layer separation grooves (21) and the front electrode layer separating grooves (41) seen in the extension direction (E) extend from an border region (5) to a further border region (5) running along an opposite substrate edge.

7. The thin-film solar module according to one of the preceding claims, **characterized in that** the thin-film solar module is designed as a substrate module whose active layer (3) is formed as a CIS or CIGS layer.

## Revendications

1. Un module solaire à couche mince, comprenant:
- un substrat (1) avec des bords de substrat et une section de bordure se déroulant le long des bords du substrat;
- une couche d'électrode arrière (2) disposée sur le substrat (1) et divisée par une pluralité de rainures de séparation de couche d'électrode arrière (21) dans des bandes de couche d'électrode arrière s'étendant le long d'une direction d'extension (E);
- une couche active (3) disposée sur la couche d'électrode arrière (2) et divisée par une pluralité de rainures de séparation de couche active (31) dans des bandes de couche active s'étendant le long de la direction d'extension (E);
- une couche d'électrode avant (4) disposée sur la couche active (3) et divisée par une pluralité de rainures de séparation de couche d'électrode avant (41) dans des bandes de couche d'électrode avant s'étendant le long de la direction d'extension (E);
- une région de bordure (5) s'étendant perpendiculairement à la direction d'extension (E) le long de la section de bordure du substrat, dans laquelle le substrat (1) est découverte de la couche d'électrode arrière (2), la couche active (3) et la couche d'électrode avant (4); et
- une rainure d'isolation électrique (6) s'étendant perpendiculairement à la direction d'extension (E) et disposée à distance de la région de bordure (5),
dans lequel la couche active (3) est découverte de la couche d'électrode avant (4) dans la rainure d'isolation électrique (6),
**caractérisé en ce que** la couche d'électrode arrière (2) en dessous de la rainure d'isolation électrique (6) est limitée par une tranchée d'isolation (7) qui s'étend perpendiculairement à la direction d'extension (E).

2. Le module solaire à couche mince selon l'une des revendications précédentes, **caractérisé par** une couche tampon (8) qui est disposée sur la couche active (3) et est divisée par la pluralité de rainures de séparation de couche active (31).

3. Un module solaire à couche mince selon l'une des revendications précédentes, **caractérisé par** une couche barrière non conductrice (9) servant de barrière à la diffusion entre le substrat (1) et la couche d'électrode arrière (2).

4. Un module solaire à couche mince selon la revendication 3, **caractérisé en ce que** le substrat (1) est découvert de la couche barrière non conductrice (9) dans la région de bordure (5).

5. Un module solaire à couche mince selon l'une des revendications précédentes, **caractérisé en ce que** les rainures de séparation de couche active (31) vues dans la direction d'extension (E) ont une longueur plus courte que les rainures de séparation de la couche d'électrode arrière (21) et les rainures de séparation de la couche d'électrode avant (41).

6. Module solaire à couche mince selon l'une des revendications précédentes, **caractérisé en ce que** les rainures de séparation de la couche active (31) vues dans la direction d'extension (E) s'étendent d'une rainure d'isolation électrique (6) à une autre rainure d'isolation électrique (6) se déroulant le long d'un bord du substrat opposé et les rainures de séparation de la couche d'électrode arrière (21) et les rainures de séparation de la couche d'électrode avant (41) vues dans la direction d'extension (E) s'étendent d'une région de bordure (5) à une autre région de bordure (5) se déroulant le long d'un bord du substrat opposé.

7. Un module solaire à couche mince selon l'une des revendications précédentes, **caractérisé en ce que** le module solaire à couche mince est conçu en tant que module de substrat dont la couche active (3) est formée en tant que couche CIS ou CIGS.
